## Europäisches Patentamt

## European Patent Office

## Office européen des brevets

(11) Publication number: **0 177 251**
**B1**

(12) **EUROPEAN PATENT SPECIFICATION**

(45) Date of publication of patent specification: **29.11.89**

(51) Int. Cl.⁴: **H 01 L 23/48**

(21) Application number: **85306788.2**

(22) Date of filing: **24.09.85**

(54) A semiconductor device having a reliable bonding pad structure.

(30) Priority: **25.09.84 JP 200225/84**

(43) Date of publication of application:
**09.04.86 Bulletin 86/15**

(45) Publication of the grant of the patent:
**29.11.89 Bulletin 89/48**

(84) Designated Contracting States:
**DE GB IT**

(56) References cited:
**US-A-4 060 828**
**US-A-4 263 606**

(73) Proprietor: **NEC CORPORATION**
**33-1, Shiba 5-chome, Minato-ku**
**Tokyo 108 (JP)**

(72) Inventor: **Tomita, Yukio**
**c/o NEC Corporation 33-1 Shiba 5-chome**
**Minato-ku Tokyo (JP)**

(74) Representative: **Pritchard, Colin Hubert et al**
**Mathys & Squire 10 Fleet Street**
**London EC4Y 1AY (GB)**

## Description

The present invention relates to a semiconductor device having a reliable bonding pad structure, and more particularly to an integrated circuit having a bonding pad which protects the insulating layer thereunder from cracking in a wire bonding process.

A semiconductor device in the prior art is formed in a semiconductor substrate. One or more electrical elements are constructed in the semiconductor substrate by selectively diffusing impurities. A wiring layer is applied on an insulating layer and connected to the circuit element through holes in the insulating layer. The wiring layer is covered by another insulating layer except for bonding pad regions. A bonding pad metal is deposited to cover the exposed bonding pad region of the wiring layer. The bonding wire is bonded onto the bonding pad metal.

The other insulating layer is a passivation layer in a case where the semiconductor device is a discrete circuit element or an integrated circuit having a small integration density, and is an intermediate layer in a case of an integrated device in which the bonding pad metal is used as an uppermost wiring layer. In any case, the other insulating layer is interposed in the peripheral portion of the bonding pad region between the lower wiring layer and the bonding pad metal. Therefore, the bonding stress is applied to the interposed insulating layer to cause cracking in the interposed insulating layer, when the bonding wire is bonded onto the bonding pad metal. The generation of cracking is enhanced by uneven surface of the bonding pad region. The unevenness is caused by the interposition of the other insulating layer at the periphery of the bonding pad region.

The cracking allows moisture to permeate into the wiring metal and corrode the wiring metal. Due to this corrosion, the resistance of the wiring metal becomes high and, in the worst case, the wiring become open to destroy the electrical function of the semiconductor device.

US—A—4,060,828 refers to prior art wherein a first insulating layer covers a surface of a semiconductor substrate having circuit elements therein. A first wiring layer is formed in a predetermined pattern on the first insulating layer and is connected with the circuit elements via windows in the insulating layer. A second insulating layer covers the first insulating layer and the first wiring layer, except on a region where there is an opening in the second insulating layer. A second wiring layer is formed in this opening and extends on to a part of the second insulating layer which is on the first insulating layer and on to a part of the second insulating layer which is on the first wiring layer. A wire is bonded to the extended part of the second wiring layer.

The primary object of the present invention is to provide a semiconductor device having a bonding pad structure which does not damage the electrical function of the semiconductor device in a wire bonding process.

The other object of the present invention is to provide a bonding pad structure by which the insulating layer at the periphery thereof is prevented from cracking in a wire bonding process.

According to the present invention, there is provided a semiconductor device comprising a semiconductor substrate in which at least one electrical circuit element is formed, a first insulating layer formed on said semiconductor substrate and having holes exposing portions of said electrical circuit element, a first metal layer selectively formed on said first insulating layer and contacting said electrical circuit element through said holes to form a wiring, a second insulating layer formed on said insulating layer and said first metal layer except for a limited portion of said first metal layer, a second metal layer formed on said limited portion of said first metal layer and extending on to a part of said second insulating layer which is on said first insulating layer, and a conductive wire bonded on said extended portion of said second metal layer, characterised in that said first metal layer has a ring-shaped portion which is exposed through a ring-shaped opening in said second insulating layer, said second metal layer contacts said first metal layer through said ring-shaped opening and extends on to a flat portion of said second insulating layer which is surrounded by said ring-shaped opening, and said conductive wire is bonded on to the extended portion of said second metal layer which is positioned above said flat portion of said second insulating layer.

In accordance with the present invention, the bonding pad is formed on the second insulating layer. All the layers under the bonding pad can be made flat. When the bonding stress is applied to the bonding pad, this flatness uniformly distributes the bonding stress over the second insulating layer under the bonding pad. Therefore, the generation of the cracking in the second insulating layer is prevented. If the bonding pad covers an edge of the limited area of the first metal, a step is formed in the second insulating layer and the cracking is easily generated in the second insulating layer at this step area. However, the step area is widely covered with the second metal. Therefore, if the crack is generated in the second insulating layer, the crack is covered with the second metal to prevent the penetration of moisture, resulting in a perfect prevention of the electrical function of the semiconductor device.

The invention will now be described, by way of example, with reference to the accompanying drawings, in which:-

Fig. 1 is a sectional view of a semiconductor device in the prior art; and

Fig. 2 is a sectional view of a semiconductor device according to an embodiment of the present invention.

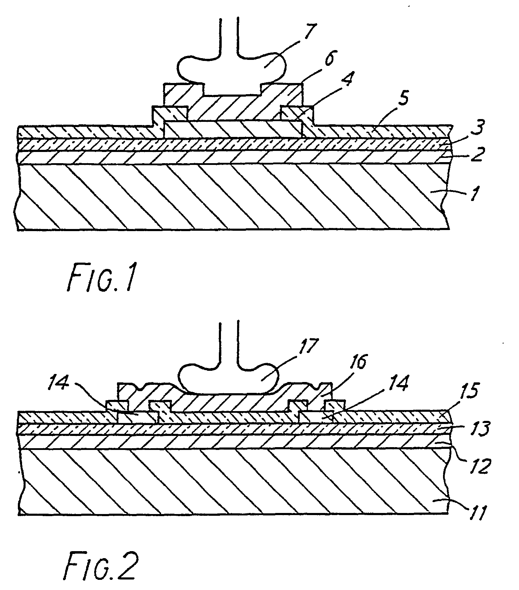

The semiconductor device in the prior art shown in Fig. 1 uses a semiconductor substrate 1 of silicon having one conductivity type.

One or more circuit elements are formed in the semiconductor substrate 1 by one or more times of impurity diffusion. One example is a diffusion region 2 which is a base region of a bipolar transistor or a resistor. The diffusion region 2 may be a channel stopper region in a MOS integrated circuit. The surface of the substrate 1 (the surface of the diffusion region 2 in Fig. 1) is covered with a first insulating layer 3 which has some holes (not shown in Fig. 1) to expose parts of circuit element to connect with wiring metal 4. The wiring metal 4 is selectively formed on the first insulating layer 3 and is contacted with the exposed part of circuit element to form a wiring. A second insulating layer 5 is further covered over the first insulating layer and the wiring metal 4 except for a limited portion. At the periphery of the limited portion of the wiring metal 4, the second insulating layer 5 covers the wiring metal 4. A bonding pad metal 6 is deposited on the limited portion of the wiring metal 4 so as to extend on the second insulating layer 5 at the periphery of the limited portion of the wiring metal 4. On the bonding pad metal 6, a gold fine wire 7 is bonded to connect with external lead of the package of the semiconductor device. The bonding pad metal 6 may be used as upper most wiring layer in an integrated circuit having a high integration density.

At the periphery of the bonding pad metal 6, the second insulating layer 6 is interposed between the bonding pad metal 6 and the wiring metal 4 and the edge of the second insulating layer 6 exists under the bonding pad metal 6 to form a step. When the gold fine wire 7 is bonded onto the bonding pad metal 6, the bonding stress concentrates at the edge portion of the second insulating layer 5 to generate cracks in the second insulating layer 5. Those cracks allow moisture to permeate to reach the wiring metal 4. The moisture oxidizes the wiring metal 4 to make wiring resistance high. In the worst case, the moisture corrodes the wiring metal 4 to make the wiring open.

Detailed Description of the Invention

In accordance with the embodiment of the present invention shown in Fig. 2, one or more circuit elements are formed in a semiconductor substrate 11 by forming a diffusion region 12 by one or more times of impurity diffusion process, as similarly to the prior art shown in Fig. 1. A first insulating layer 13 is formed on the semiconductor substrate 11 (in the case of Fig. 2, the first insulating layer 13 covers the diffusion region 12). A wiring metal 14 of Al is selectively deposited on the first insulating layer 13. The wiring metal 14 is connected with the circuit element through holes in the first insulating layer 13 to form wirings. At a portion of bonding pad, the wiring metal 14 is formed as a ring-shape surrounding the bonding pad portion. A second insulating layer 15 is formed on the first insulating layer 13 and the wiring metal 14 except for a ring-shaped portion of the wiring metal 14. The second insulating layer 15 is flat at the bonding pad portion surrounded by the ring-shape wiring metal 14. A bonding pad metal 16 of Al is deposited on the ring-shape wiring metal 14 and the bonding pad portion of the second insulating layer 15. A gold fine wire 17 is bonded onto the bonding pad metal 16 upon the second insulating layer 15 surrounded by the ring-shape wiring metal 14. The other end of the gold fine wire 17 is connected with an external lead of package or directly with other electrical circuit element. The bonding pad metal 16 may be used as an uppermost wiring metal in a case of integrated circuit in which a multi-layer wiring is employed.

All the layers, such as the bonding pad metal 16 and the second and first insulating layers 15 and 13, are made flat at a portion where the gold fine wire 17 is bonded. The bonding stress is uniformly applied to anywhere in the second insulating layer 15 under the gold fine wire 17. It is hard to generate crack in the second insulating layer 15. Furthermore, even if a crack is generated in the second insulating layer 15, the cracking portion is covered with the bonding pad metal 16 and is not extended outside the bonding pad metal 16 by the separation of the second insulating layer 16 on the ring-shape portion of the wiring metal 14. Therefore, the wiring metal 14 is kept separation from moisture to prevent from being oxidized or corroded. The electrical characteristics of the semiconductor device is not affected by the bonding process.

The present invention is equally applied to a discrete semiconductor device or an integrated circuit having a single wiring layer by using the second insulating layer 14 as a passivation layer and to an integrated circuit having a multi-layer wirings by using the bonding pad metal 15, and the second insulating layer 14 as an uppermost wiring layer and an interposed insulating layer, respectively.

**Claim**

1. A semiconductor device comprising a semiconductor substrate (11,12) in which at least one electrical circuit element is formed, a first insulating layer (13) formed on said semiconductor substrate (11,12) and having holes exposing portions of said electrical circuit element, a first metal layer (14) selectively formed on said first insulating layer (13) and contacting said electrical circuit element through said holes to form a wiring, a second insulating layer (15) formed on said insulating layer (13) and said first metal layer (14) except for a limited portion of said first metal layer (14), a second metal layer (16) formed on said limited portion of said first metal layer (14) and extending on to a part of said second insulating layer (15) which is on said first insulating layer, and a conductive wire (17) bonded on said extended portion of said second metal layer (16), characterised in that said first metal layer (14) has a ring-shaped portion which is exposed through a ring-shaped opening in said second insulating layer (15), said second metal layer (16) contacts said first metal layer (14) through said ring-shaped opening and extends on to a flat portion of said second insulating layer (15) which is surrounded by said ring-shaped opening, and said conductive wire (17) is bonded on to the extended portion of said second metal layer (16) which is positioned above said flat portion of said second insulating layer (15).

## Patentanspruch

1. Halbleiterbauelement mit einem Halbleitersubstrat (11, 12) indem wenigstens ein elektrisches Schaltelement ausgebildet ist, einer ersten Isolierschicht (13), die auf dem Halbleitersubstrat (11, 12) ausgebildet ist und Löcher hat, die Bereiche des elektrischen Schaltelementes freigeben, einer ersten Metallschicht (14), die teilweise auf der ersten Isolierschicht (13) ausgebildet ist und das elektrische Schaltelement durch die Löcher kontaktiert, um eine Verdrahtung zu bilden, einer zweiten Isolierschicht (15), die auf der Isolierschicht (13) und der ersten Metallschicht (14) ausgebildet ist außer auf einem begrenzten Bereich der ersten Metallschicht (14), einer zweiten Metallschicht (16), die auf dem begrenzten Bereich der ersten Metallschicht (14) ausgebildet ist und auf einen Teil der zweiten Isolierschicht (15), die sich auf der ersten Isolierschicht befindet, verlängert ist, und mit einem leitfähigen Draht (17), der auf dem verlängerten Bereich der zweiten Metallschicht (16) aufgebracht ist, dadurch gekennzeichnet, daß die erste Metallschicht (14) einen ringförmigen Bereich hat, der durch eine ringförmige Öffnung in der zweiten Isolierschicht (15) freigelegt ist, wobei die zweite Metallschicht (16) die erste Metallschicht (14) durch die ringförmige Öffnung hindurch berührt und auf einen flachen Bereich der zweiten Isolierschicht (15), der von der ringförmigen Öffnung umgeben wird, verlängert ist, und wobei der leitfähige Draht (17) auf dem verlängerten Bereich der ersten Metallschicht (16), der über dem flachen Bereich der zweiten Isolierschicht (15) liegt, aufgebondet ist.

## Revendication

1. Dispositif à semi-conducteur comprenant un substrat à semi-conducteur (11, 12) dans lequel au moins un élément de circuit électrique est formé, une première couche isolante (13) formée sur le substrat à semi-conducteur (11, 12) et ayant des trous exposant des parties de l'élément de circuit électrique, une première couche métallique (14) formée sélectivement sur la première couche isolante (13) et en contact avec l'élément de circuit électrique par l'intermédiaire des trous pour former un câblage, une seconde couche isolante (15) formée sur la couche isolante (13) et la première couche métallique (14) à l'exception d'une partie limitée de la première couche métallique (14), une seconde couche métallique (16) formée sur la partie limitée de la première couche métallique (14) et s'étendant sur une partie de la seconde couche isolante (15) qui se trouve sur la première couche isolante, et un fil conducteur (17) lié à la partie étendue de la seconde couche métallique (16), caractérisé en ce que la première couche métallique (14) a une portion en forme d'anneau qui est exposée par l'intermédiaire d'une ouverture en forme d'anneau ménagée dans la seconde couche isolante (15), la seconde couche métallique (16) est en contact avec la première couche métallique (14) par l'intermédiaire de l'ouverture en forme d'anneau et s'étend sur une partie plate de la seconde couche isolante (15) qui est entourée par l'ouverture en forme d'anneau, et le fil conducteur (17) est lié à la partie étendue de la seconde couche métallique (16) qui est placée au-dessus de la partie plate de la seconde couche isolante (15).

FIG.1

FIG.2